# EUROPÄISCHE PATENTSCHRIFT

(11) **EP 0 774 831 B1**
(45) Veröffentlichungstag und Bekanntmachung des Hinweises auf die Patenterteilung: **08.11.2000**
(21) Anmeldenummer: 96115256.8
(22) Anmeldetag: 24.09.1996
(51) Int. Cl.: H03B 19/16

(54) **Schaltungsanordnung zur Erzeugung einer Taktfrequenz für ein Datenübertragungssystem**
Circuit arrangement for generating a clock frequency for a data transmission system
Agencement de circuit pour générer une fréquence d'horloge pour un système de transmission de données

(30) Priorität: 18.11.1995 DE 19543115
(43) Veröffentlichungstag der Anmeldung: 21.05.1997
(73) Patentinhaber: KE KOMMUNIKATIONS-ELEKTRONIK GMBH & CO, D-30179 Hannover (DE)
(72) Erfinder: Hennig, Andreas, Dipl.-Ing., 30827 Garbsen (DE)
(74) Vertreter: Döring, Roger, Dipl.-Ing.

(56) Entgegenhaltungen:
- US-A- 3 593 156
- US-A- 4 213 185
- US-A- 5 434 522
- MARTIN R ET AL: "A KU-BAND OSCILLATOR SUBSYSTEM USING A BROADBAND GAAS MMIC PUSH-PULL AMPLIFIER/DOUBLER" IEEE MICROWAVE AND GUIDED WAVE LETTERS, Bd. 1, Nr. 11, 1.November 1991, Seiten 348-350, XP000230630

## Beschreibung

Die Erfindung bezieht sich auf eine Schaltungsanordnung zur Erzeugung einer Taktfrequenz für ein Datenübertragungssystem unter Verwendung eines spannungsgesteuerten Grundwellen-Quarzoszillators, dessen Frequenz in Abhängigkeit von der Steuerspannung in engen Grenzen veränderbar ist (DE-Buch von Tietze/Schenk, "Halbleiter-Schaltungstechnik", 9. Auflage, 1990, Springer-Verlag, Seite 468).

Für digitale Schaltwerke allgemein und Datenübertragungssysteme im besonderen werden für die aktiven Komponenten Taktfrequenzen benötigt. Ein solches Datenübertragungssystem ist beispielsweise das HDSL-System, mit einem Frequenzbereich von etwa 50 kHz bis 500 kHz. Als Erzeuger derartiger Frequenzen sind spannungsgesteuerte Quarzoszillatoren - im folgenden mit "VCXO" bezeichnet - bekannt. Es handelt sich gemäß dem erwähnten DE-Buch beispielsweise um Pierce-Oszillatoren. Eine Veränderung der Steuerspannung eines solchen VCXOs führt zu einer Änderung der Frequenz desselben. Diese Änderung ist begrenzt. Der Bereich zwischen maximaler und minimaler Frequenz wird als "Ziehbereich" bezeichnet. Bei einer Frequenz von 28 MHz ist der Ziehbereich beispielsweise etwa ± 100 ppm, also ± 2,8 kHz. Der Ziehbereich wird mit steigender Oberwellenordnung kleiner.

Auf dem Markt sind Grundwellen-VCXOs mit Frequenzen bis zu 40 MHz erhältlich. Für noch höhere Frequenzen werden nahezu ausschließlich Oberwellen-VCXOs angeboten, die gegenüber den Grundwellen-VCXOs einen deutlich eingeschränkten Ziehbereich haben. Für viele Datenübertragungssysteme werden aber Taktfrequenzen mit einem breiten Ziehbereich benötigt, die höher als 40 MHz sind. Das gilt beispielsweise für Datenübertragungssysteme mit Schaltungen mit digitalen Filterketten im Empfänger.

Aus der US-Z "IEEE Microwave and Guided Wave Letters", Vol. 1, No. 11, November 1991, Seiten 348 bis 350 ist eine Schaltungsanordnung zur Frequenzverdopplung mit einem spannungsgesteuerten Grundwellen-Quarzoszillator bekannt. Dem Quarzoszillator ist eine Frequenzverdoppler-Schaltung nachgeschaltet, die aus einem Gegentaktverstärker mit Eintaktausgang besteht. Die Grundwellenfrequenz wird unterdrückt.

Die US-A-5,434,522 beschreibt eine Schaltungsanordnung zur Frequenzverdoppelung, mit der die Grundwellenfrequenz und ungeradzahlige Harmonische unterdrückt werden sollen. Eine Signalquelle ist über einen Kondensator an den Eingang eines Zweiweggleichrichters angeschlossen, dessen Ausgang mit einem Differentialverstärker verbunden ist.

Der Erfindung liegt die Aufgabe zugrunde, die eingangs geschilderte Schaltungsanordnung so zu gestalten, daß unter Einsatz eines Grundwellen-VCXOs eine über 40 MHz liegende Frequenz mit einem über ± 100 ppm liegenden Ziehbereich erhalten wird.

Diese Aufgabe wird gemäß der Erfindung dadurch gelöst,
- daß der Ausgang des Grundwellen-Quarzoszillators, an dem eine sinusförmige Frequenz zur Verfügung steht, mit dem Eingang einer Gleichrichter-Brückenschaltung verbunden ist, über deren Ausgang ein ohmscher Widerstand liegt, wobei die Anschlüsse des ohmschen Widerstands jeweils mit einem Ausgangsanschluß der Gleichrichter-Brückenschaltung verbunden sind,
- daß an den ohmschen Widerstand ein Komparator mit seinen beiden Eingängen angeschlossen ist, an dessen Ausgang die Taktfrequenz ansteht und
- daß zwischen dem ohmschen Widerstand und dem Komparator ein aus einem Kondensator und einem hochohmigen Widerstand bestehender Hochpaß eingeschaltet ist.

Als Basis für diese Schaltungsanordnung wird ein mit der Grundwelle schwingender VCXO mit einer relativ niedrigen Frequenz von beispielsweise 28 MHz verwendet. Die Frequenz des eingesetzten VCXO wird mit dieser Schaltungsanordnung verdoppelt. Sie beträgt also beispielsweise 56 MHz. Der für den mit niedriger Frequenz schwingenden VCXO geltende breite Ziehbereich von > ± 100 ppm bleibt voll erhalten. Am Ausgang des Komparators steht damit eine hohe Frequenz (Rechteckfrequenz) mit breitem Ziehbereich zur Verfügung, die durch den Komparator noch verstärkt ist. Der Gleichspannungsteil der durch die Brückenschaltung gewonnenen Frequenz wird durch den am Eingang des Komparators angeschlossenen Hochpaß unterdrückt, der aus einem Kondensator und einem hochohmigen Widerstand besteht.

Ein Ausführungsbeispiel des Erfindungsgegenstandes ist in den Zeichnungen dargestellt.

Es zeigen:

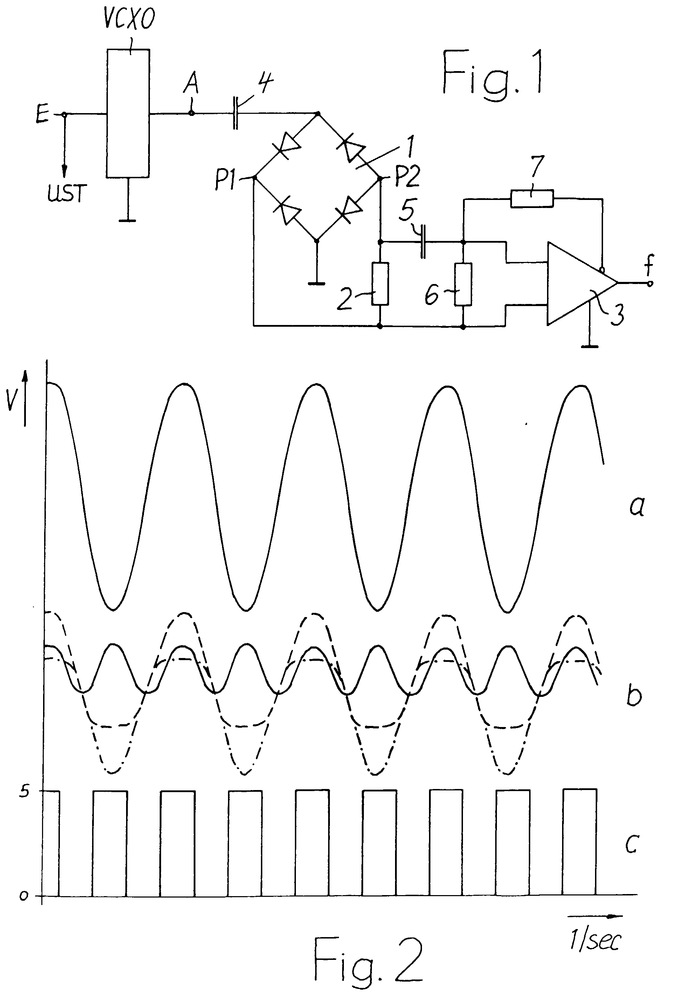

Fig. 1 eine Schaltungsanordnung nach der Erfindung.
Fig. 2 Kurvenverläufe von Frequenzen an unterschiedlichen Punkten der Schaltungsanordnung.

Mit VCXO ist ein Grundwellen-Quarzoszillator bezeichnet, dessen Aufbau grundsätzlich bekannt ist. Es wird daher nicht näher auf denselben eingegangen. Der VCXO ist spannungsgesteuert. Durch eine Änderung der am Eingang E des VCXO anliegenden Steuerspannung UST in engen Grenzen von beispielsweise 0V bis 5V, kann die Frequenz des VCXO in einem Ziehbereich von >± 100 ppm verändert werden. Das kann zur Anpassung an Bauteile der Schaltungsanordnung einschließlich der Datenübertragungsstrecke erforderlich sein. Am Ausgang A des VCXO soll ein möglichst klirrarmes Signal zur Verfügung stehen. Die am Ausgang A gegebene Frequenz ist daher sinusförmig, so wie es aus Fig. 2a hervorgeht.

Die vom VCXO erzeugte Frequenz wird einer Gleichrichter-Brückenschaltung 1 - im folgenden "Brücke 1" genannt - zugeführt, über deren Ausgang ein ohmscher Widerstand 2 liegt. An den Widerstand 2 ist ein Komparator 3 mit seinen beiden Eingängen angeschlossen. Zur Unterdrückung von Gleichanteilen der vom VCXO erzeugten Frequenz kann zwischen dem Ausgang A desselben und der Brücke 1 ein Kondensator 4 eingeschaltet sein. Zur Unterdrückung von Gleichanteilen der am Widerstand 2 anliegenden Frequenz ist am Eingang des Komparators 3 ein Hochpaß eingeschaltet, der aus einem Kondensator 5 und einem hochohmigen Widerstand 6 besteht.

Durch die Brücke 1 erfolgt eine Invertierung der negativen Halbwelle der vom VCXO erzeugten Frequenz. Dementsprechend liegt am Pol P1 der Brücke 1 das in Fig. 2b gestrichelt eingezeichnete Ausgangssignal an, während am Pol P2 der Brücke 1 das strichpunktierte gezeichnete Ausgangssignal zur Verfügung steht.

Diese beiden Ausgangssignale werden dem Widerstand 2 aufgegeben. An den beiden Eingängen des Komparators 3 liegt damit eine Frequenz an, die in Fig. 2b ausgezogen eingezeichnet ist. Sie ist gegenüber der Frequenz des VCXO verdoppelt. Am Ausgang des Komparators 3, der als Verstärker wirkt, steht die aus Fig. 2c ersichtliche Taktfrequenz f zur Verfügung, die gegenüber der Frequenz des VCXO verdoppelt ist und deren Ziehbereich unverändert dem Ziehbereich des VCXO entspricht. Der Ausgangspegel des Komparators 3 entspricht dem TTL-Pegel, der beispielsweise zwischen 0V und 5V liegt.

Das Tastverhältnis des Komparators 3 soll nach Möglichkeit bei 1:1 liegen. Um hier eine Korrektur durchführen zu können, ist ein ohmscher Widerstand 7 vorgesehen, über den das Ausgangssignal des Komparators 3 auf einen seiner Eingänge rückgekoppelt ist.

## Patentansprüche

1. Schaltungsanordnung zur Erzeugung einer Taktfrequenz für ein Datenübertragungssystem unter Verwendung eines spannungsgesteuerten Grundwellen-Quarzoszillators, dessen Frequenz in Abhängigkeit von der Steuerspannung in engen Grenzen veränderbar ist, dadurch gekennzeichnet,
- daß der Ausgang (A) des Grundwellen-Quarzoszillators (VCXO), an dem eine sinusförmige Frequenz zur Verfügung steht, mit dem Eingang einer Gleichrichter-Brückenschaltung(1) verbunden ist, über deren Ausgang ein ohmscher Widerstand (2) liegt, wobei die Anschlüsse des ohmschen Widerstands (2) jeweils mit einem Ausgangsanschluß (P₁, P₂) der Gleichrichter-Brückenschaltung (1) verbunden sind,
- daß an den ohmschen Widerstand (2) ein Komparator (3) mit seinen beiden Eingängen angeschlossen ist, an dessen Ausgang die Taktfrequenz (f) ansteht und
- daß zwischen dem ohmschen Widerstand (2) und dem Komparator (3) ein aus einem Kondensator (5) und einem hochohmigen Widerstand (6) bestehender Hochpaß eingeschaltet ist.

## Claims

1. A circuit arrangement to generate a clock frequency for a data transmission system, comprising a voltage-controlled fundamental wave quartz oscillator, the frequency of which is changeable within narrow limits depending on the control voltage,
characterized in
- that the output (A) of the fundamental wave quartz oscillator (VCXO), at which a sinusoidal frequency is available, is connected to the input of a rectifier bridge circuit (1), the output of the rectifier bridge circuit (1) being connected to an ohmic resistance (2), wherein the contacts of the ohmic resistance (2) respectively are connected to one of the output poles (P1, P2) of the rectifier bridge circuit (1),
- that a comparator (3) having two inputs and an output is connected to the ohmic resistance (2), the clock frequency (f) being provided at the ouput of the comparator (3), and
- that a high-pass filter including a capacitor (5) and a high-impedance resistor (6) is connected between the ohmic resistance (2) and the comparator (3).

## Revendications

1. Montage de circuit produisant une fréquence d'horloge pour un système de transmission de données grâce à l'utilisation d'un oscillateur à quartz à ondes dominantes commandé par tension dont la fréquence est, dans une marge restreinte, modifiable selon la tension de commande, caractérisé par:
- la sortie (A) de l'oscillateur à quartz à ondes dominantes (VCXO), qui dispose d'une fréquence sinusoïdale, est reliée à l'entrée d'un redresseur de pont (1) sur la sortie duquel est placée une résistance ohmique (2), dont chacune des branches est reliée à la connexion de sortie du redresseur de pont (1).
- les deux entrées du comparateur (3) sont reliées à la résistance ohmique (2), à la sortie duquel la fréquence d'horloge est émise, et
- un filtre passe-haut, composé d'un condensateur (5) et d'une haute résistance ohmique (6), est inséré entre la résistance ohmique (2) et le comparateur (3).
